# EUROPEAN PATENT APPLICATION

(11) **EP 1 130 812 A2**
(43) Date of publication of application: **05.09.2001**
(21) Application number: 01301908.8
(22) Date of filing: 02.03.2001
(51) Int. Cl.: H04B 10/145, H01S 5/042, H01S 5/183

(54) **High speed modulation of semiconductor devices**

(30) Priority: 03.03.2000 CA 2300045
(71) Applicant: Mitel Semiconductor AB, 175 26 Järfälla (SE)
(72) Inventor: Sawyer, Dave, Swindon, Wiltshire (US); Isaksson, Jan, 187 43 Töby (SE)
(74) Representative: Harding, Richard Patrick

(57) **Abstract**

A system and method for achieving high speed modulation of semi-conductor devices, such as VCSELs, utilizing field effect to confine a signal path is described. In semi-conductor devices operating at high data rates the configuration of connector rails and signal paths can become a limiting factor. The present invention provides an arrangement in which the signal return path is confined relative to the energizing signal path by a field effect in a common conductor extending under the signal path.

## Description

### FIELD OF THE INVENTION

This invention relates to the high speed modulation of semi-conductor devices and, more particularly, to a method and system for providing high speed modulation signals to such devices, especially for driving optical devices, such as VCSELs (Vertical Cavity Surface Emitting Lasers).

### BACKGROUND OF THE INVENTION

In virtually every area of technology involving semi-conductor devices concentrated efforts are being made to increase the speed of operation. This is particularly true in communication systems where high data rates are needed in order to meet current and future high bandwidth demands. One of the factors which limits the speed of operation of semi-conductors is the physical limitations imposed by device contacts and connectors. As device processing techniques advance, smaller and smaller devices are capable of providing greater and greater functionality. This combination generates the need to find improved device architectures and circuit lay-outs to accommodate the higher density of active elements. As conductor lines and bonding wires necessarily become closer and closer together, the problems introduced by parasitic inductance and capacitance increases. This is particularly significant in devices and systems designed to operate at high speeds.

In the case of optical devices, it is known to mount the optical components, such as VCSELs, on the end of a "lead frame". This is a device which provides the connections to the driver circuits that supply the modulation signals to the VCSELs. A lead frame consists of a metal frame, usually made of nickel, that has a common grounded connection and a number of separate conductors leading to the individual VCSELs. The driving current passes through the individual VCSELs and back through a common ground connection usually passing around the outer portion of the lead frame. The problem in the past has been that the long common return path leads to cross-talk between the individual devices, and this is especially true at higher frequencies in the order of 2.5 Gbs and above.

An object of the invention is to alleviate this problem of cross-talk at high frequencies.

### SUMMARY OF THE INVENTION

The present invention seeks to provide a connection architecture that enables higher modulation speeds and hence higher data rates. In accordance with the principles of the invention, the return signals are kept separate from each other by configuring the device in such a way that although passing through a common conductive block, usually serving as a heat sink, the actual signals are constrained to pass under their corresponding energizing conductors due to a field effect. At low frequencies, any signals passing through a common conductor will tend to mix due to non-linear effects. However, it follows from electromagnetic theory that at high frequencies, if a series of energizing conductors leading to an active device are formed over a common metal conductor, and the common return electrode is directly connected to the common conductor at the location of the active device, the energizing conductors of course being insulated from the common conductor, the return signal will be constrained to flow under their energizing corresponding conductors due to field effects, and thus mixing of the return signals will be minimized even though the currents are flowing through a common conductor.

Therefore, in accordance with the first aspect of the present invention there is provided an optical transmitter for high speed data communication comprising an array of lasers having first and second electrical contacts on a common face opposite to an emitting face; a plurality of adjacent energizing signal lines connected respectively at their distal ends to said first contacts of said lasers; a common conductive surface under said signal lines and insulated therefrom; a conductor establishing electrical connection between said second electrical contacts and said conductive surface in the vicinity of said lasers; and driver circuitry connected to the proximal ends of said signal lines for energizing said respective lasers, said driver circuitry also being connected to said conductive surface in the vicinity of said proximal ends, whereby return signals from said second electrical contacts are constrained to flow back to said driver circuitry in discrete paths in said conductive surface under said signal lines without intermixing due to field effects.

In this way, the energizing conductors actually create separate signal channels or paths in the conductive surface, which even though they are flowing through a common metal block do not mix. Normally, the return path will be grounded and current will flow through a common metal block forming a heat sink, This structure provides a very efficient way of minimizing the path length and also minimizing cross-talk between the channels. The arrangement works best at frequencies of 2.5 Gbps and above. At lower frequencies the signals would of course tend to mix due to non-linear effects because of the fact that they are collectively glowing through a common conductor. The return electrode is normally common to all the devices, although of course this is not essential.

According to a further aspect of the present invention there is provided an optical transmitter for high speed data communication comprising an array of optical emitters each having an energizing contact and a return contact; a common conductive surface; a plurality of energizing lines for said respective emitters arranged in insulating relationship with said conductive surface; and at least one return electrode connected to said return contacts and directly connected to said conductive surface; wherein return signals flow through said common conductive a return path confined by a field effect due to said connector line.

In accordance with a preferred embodiment of this aspect of the invention, a plurality of VCSELs are provided, each having a separate connector line for the first contact and the return path for each is confined by a field effect to a region defined by the line connector.

According to a further aspect of the invention, there is provided an array of VCSELs for high speed data communication, each of the VCSELs having an input contact and a ground contact and a common face which is opposite to the surface emitting face, the array mounted on an insolating carrier having on one face a separate line connection for each input contact and a ground plane on the opposite face, the ground plane connected to each ground contact on the VCSEL wherein the ground plane signal for each VCSEL is confined by a field effect to a narrow region opposite the line connection for each input contact.

### BRIEF DESCRIPTION OF THE DRAWINGS

The invention will now be described in greater detail with reference to the attached drawings wherein:
Figure 1 is a perspective view of an optical transceiver that incorporates the concept of the present invention;
Figure 2 is a plan view of the optical transducer shown in Figure 1;
Figure 3 is a plan view of one form of the mounting arrangement according to one aspect of the invention;
Figure 4 is a end view of the optical transceiver of Figure 1 illustrating one version of the connection arrangement according to the invention; and
Figure 5 is an edge view of the connection arrangement of Figure 4.

### DETAILED DESCRIPTION OF THE INVENTION

The exemplary embodiment of the present invention relates to an optical transmitter or transceiver for use in a high speed interconnection link between data equipment. The device is intended to operate at 2.5Gbps, although it will be understood that the same principle can also be applied at other high frequencies. It is envisaged that the device can be used up to frequencies of 30 Gbs and higher. The following description of the exemplary embodiment is intended to provide a general description of the basic concept of the invention and is not intended to limit the scope thereof.

In an optical transmitter or transceiver light emitting devices such as solid state lasers are used to generate the optical signal. Lasers such as Vertical Cavity Surface Emitting Lasers (VCSELs) are used in a preferred embodiment as they are typically processed in accordance with well proven processing techniques resulting in reliable sources. Additionally alloy compounds used in fabricating such devices can be tailored to generate optical energy that is readily detected by known photo detectors, such as PIN diodes. VCSELs can be produced in arrays or as discrete devices depending on end system requirements. Typically, VCSELs are produced in banks of four. In the embodiment described here a plurality of VCSELs are used to produce a multi-channel optical transmitter. Some of the VCSELs could be replaced with PIN diodes or similar devices to provide an optical receiver.

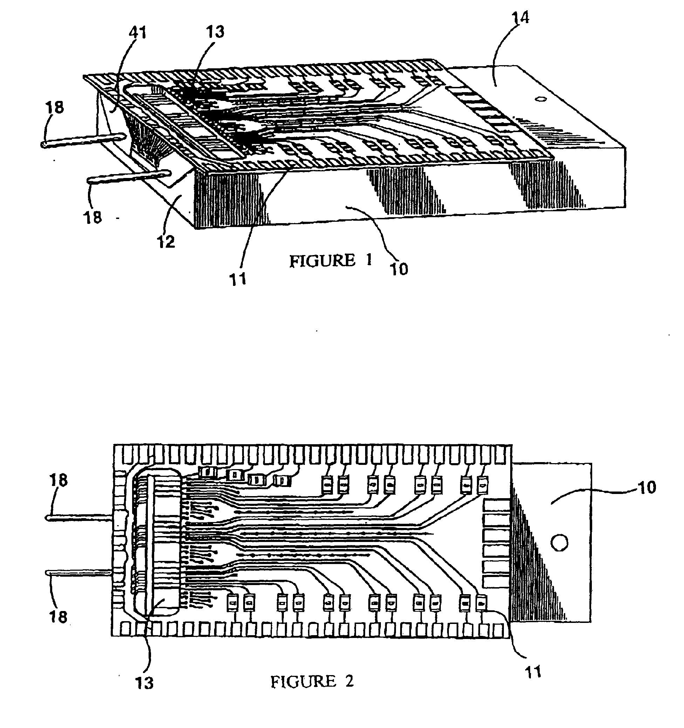

In the optical transceiver partially shown in Figures 1 and 2 the VCSEL array (not shown) is located on end face 12 of a solid conductive block 10 forming a heat sink. A printed circuit 11, including driver chips 13, is mounted on top face 14 of the conductive block 10. The driver chips 13 can be, for example, provided by AMCC corporation, and may include differential common mode logic (CML) circuitry for providing the modulating signals to the VCSELs is on top face 14.

Alignment or guide pins 18 on end face 12 serve to accurately position the VCSEL array in relation to an optic fiber ferrule (not shown) for coupling the optical output from the transmitters to a downstream optical receiver. Additionally, the alignment pins 18 can be used to accurately align the array relative to the front face 12. Further details with respect to the alignment pins may be found in co-pending Canadian Patent Application No. 2,242,710 filed September 29, 1998, and assigned to the present Applicant

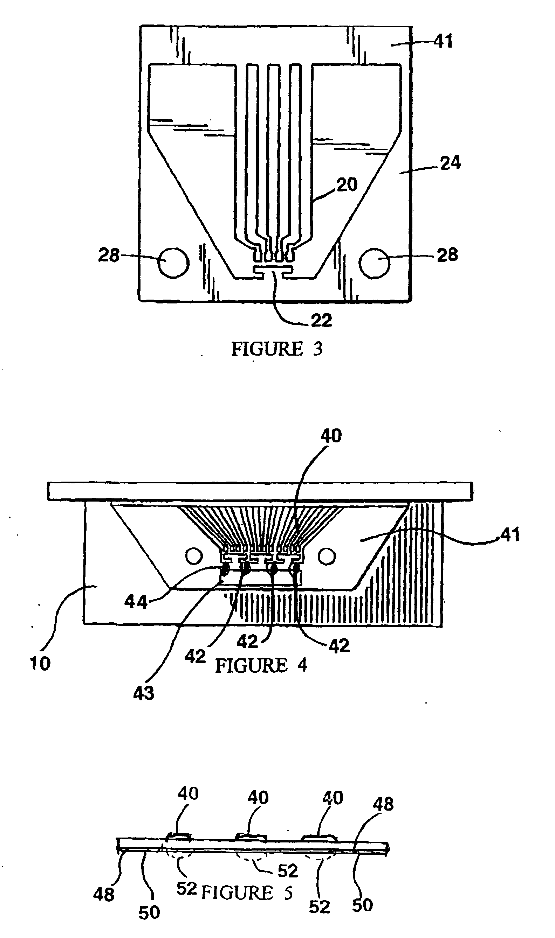

The architecture of the VCSELs used in a preferred embodiment of the invention is such that both P and N type contacts are both on the back face, i.e. the face opposite to the emitting face. An example of a prior art lead frame that provides energizing signals to a four VCSEL array is shown in Figure 3. The VCSEL array is bonded to the connector lines 20 and pad 22 such that one contact, for example the P contact, of each VCSEL is connected to separate lines 20 and the N contact is provided by pad 22. Thus by providing modulating signals to lines 20 each VCSEL is independently activated. In prior art the return signal is carried via path 24. End strip 26 is removed after the lead frame has been mounted on a suitable carrier. Apertures 28 in Figure 3 are used to accurately align the VCSEL array to the lead frame. This structure is described in the aforementioned co-pending Canadian Patent Application No. 2,242,710.

In a typical connection arrangement wherein modulating signals are provided to semi-conductor devices and arrays the energizing signal and return path run side-by-side. In a high density configuration the extremely close proximity of these conductors rails, particularly if the VCSELs are operating at very high speeds, parasitic inductance between rails can lead to cross-talk and generally limit the maximum modulation rates. Additionally, the typical connection arrangement requires more bonding wires that are needed to join components and connector pads. These additional bonding wires also close to each other add further inductance and cross talk problems. Also, because the signals flow through the common return path 24, any non-linearities will cause mixing of the signals and thus cross-talk. This is especially true at high frequencies.

According to the present invention, only the energizing path for each device is provided in a parallel arrangement. This means that the separation between rails can be greater thereby reducing the potential cross-talk. Figure 4 illustrates one example of a mounting/contacting arrangement for a twelve channel optical transmitter utilizing. VCSEL arrays. The arrays are arranged in banks of four per chip and are mounted so as to bridge the ends of signal lines 40 and the ground pads 42.

The arrangement illustrated in Figure 4 is an expanded view of the contact configuration shown on the end face of the optical transmitter of Figure 1. In this case the individual signal lines 40 for each VCSEL forming part of a lead frame 41 terminate adjacent the ground pad 42. The lead frame is typically made of plated nickel and provides the connection between the driver circuitry and the VCSELs. The ground or N contact is returned via solder connections 43, which connect the ground pads 42 directly to the underlying mounting block 10 at locations in the vicinity of the VCSELs and the distal ends of the energizing lines 40.

The lead frame 41 is typically bonded onto the end face 12 of the block 10 by epoxy resin or the like which also serves as an insulating layer.

The return path is via the mounting block 10 as shown at in Figure 1. Alternatively, a conductive sheet (not shown) can be placed under the signals lines and insulated there from.

It has been established that under these circumstances the return path is, in fact, confined to a narrow region beneath the energizing line due to field and skin effects. When an outbound signal travels through a conductor insulated from but extending over a conductive surface, a return signal through the conductive surface will tend to be constrained to flow in a path through the conductive surface directly under the energizing conductor. Thus, as shown in Figure 5 which is a cross sectional view of the connector line 40s, insulation layer 48 (typically epoxy resin) and part of the common conductor or back plane 10, the return path 52 under each connector line or energizing line is confined to a narrow region under the connector line by a field effect at high data rates. This effect allows higher data rates or modulation rates than can be achieved with the arrangement shown in Figure 3 where the return signal flow through a common path 24 around the side of the lead frame 41. Not only is this longer, which is a disadvantage, it also encourages intermixing between the signals.

The invention relies on the effect that if a signal line 40 is disposed over a conductive surface forming part of a conductive block, in this case the heat sink 10, such that the energizing signals from a driver circuit pass through the signal line to a VCSEL at its distal end, the return signals at the distal end are directly connected to ground provided by a common conductor, and the return signals are received from the conductor adjacent the proximal ends of the signal lines, the return signals will tend to flow back through the common conductor directly under the signal lines due to field and skin effects as if a discrete channel were present even though in fact they are all flowing through a common conductor. In other words at high frequencies, the return signals appear to remain trapped in discrete channels under their respective conductors and do not mix with each other event though they are passing through a common conductor. This effect is extremely important because it permits high frequency operation without the troublesome cross-talk that would otherwise occur.

Although the aforementioned description refers specifically to VCSELs, it is to be understood that the concept according to the present invention, is not limited to such devices. It is intended that the concept will be applicable to any semi-conductor device in which high speed modulation is a requirement.

While specific embodiments of the invention have been described and illustrated, it will be apparent to one skilled in the art that numerous modifications can be made without departing from the basic concept. It is to be understood, however, that such modifications will fall within the scope of the invention as defined by the appended claims.

## Claims

1. An optical transmitter for high speed data communication comprising an array of lasers having first and second electrical contacts on a common face opposite to an emitting face; a plurality of adjacent energizing signal lines connected respectively at their distal ends to said first contacts of said lasers; a common conductive surface under said signal lines and insulated therefrom; a conductor establishing electrical connection between said second electrical contacts and said conductive surface in the vicinity of said lasers; and driver circuitry connected to the proximal ends of said signal lines for energizing said respective lasers, said driver circuitry also being connected to said conductive surface in the vicinity of said proximal ends, whereby return signals from said second electrical contacts are constrained to flow back to said driver circuitry in discrete paths in said conductive surface under said signal lines without intermixing due to field effects.

2. An optical transmitter as claimed in claim 1, wherein said conductive surface forms part of a massive metal block.

3. An optical transmitter as claimed in claim 2, wherein said massive metal block also serves as a beat sink.

4. An optical transmitter as claimed in claim 1, wherein said lasers arc VCSELs (Vertical Cavity Surface Emitting Lasers).

5. An array of VCSELs for high speed data communications, each of said VCSELs having an input contact and a ground contact on a common face which is opposite to the surface emitting face, said array mounted on an insulating carrier having on one face a separate line connection for each input contact and a ground plane on an opposite face, said ground plane connected to each ground contact on said VCSELs, wherein said ground plane signal for each VCSEL is confined by a field effect to a narrow region opposite the line connection for each input contact.

6. An array of VCSELs as defined in claim 5 for use in conjunction with a plurality of optical waveguides for transmitting optical energy to an optical receiver.

7. An array of VCSELs as defined in claim 5 wherein optical energy is modulated at a data rate up to 2.5Gbps.

8. An array of VCSELs as defined in claim 5 wherein said insulating carrier has a pair of alignment pins in a fixed position relative to a mounting location for said VCSELs as defined by said line connections for said input contacts.

9. An array as defined in claim 8 wherein said optical waveguides are mounted in a housing having a pair of apertures for receiving said alignment pins to align said waveguides relative to said array of VCSELs.

10. A method of supplying an energizing signal to a semi-conductor device for high speed operation comprising:
providing a conductor line for supplying an energizing signal to said semi-conductor device; and
providing a return path for said energizing signal through a conducting layer isolated from said conductor line, wherein a return signal on said return path is confined by a field effect.

11. The method of claim 10 wherein said semi-conductor device is a Vertical Cavity Surface Emitting Laser (VCSEL).
